# EUROPEAN PATENT SPECIFICATION

(11) **EP 3 240 305 B1**
(45) Date of publication and mention of the grant of the patent: **25.09.2019**
(21) Application number: 15872964.0
(22) Date of filing: 21.12.2015
(51) Int. Cl.: H04R 17/00, H01L 41/047, H01L 41/083, H01L 41/113, B06B 1/06

(54) **ULTRASONIC SENSOR**
ULTRASCHALLSENSOR
CAPTEUR ULTRASONORE

(30) Priority: 24.12.2014 JP 2014260446
(43) Date of publication of application: 01.11.2017
(73) Proprietor: Murata Manufacturing Co., Ltd., Nagaokakyo-shi, Kyoto 617-8555 (JP)
(72) Inventor: WATANABE, Kosuke, Nagaokakyo-shi Kyoto 617-8555 (JP); FUJITA, Akio, Nagaokakyo-shi Kyoto 617-8555 (JP); NANBU, Koji, Nagaokakyo-shi Kyoto 617-8555 (JP)
(74) Representative: Lloyd, Patrick Alexander Desmond
(86) International application number: PCT/JP2015/085622
(87) International publication number: WO 2016/104396

(56) References cited:
- JP-A- S6 291 857
- JP-A- S6 477 299
- JP-A- H01 270 499
- JP-A- H08 173 416
- JP-A- 2002 301 037
- JP-A- 2010 069 618
- US-B1- 6 575 565

## Description

### TECHNICAL FIELD

The present invention relates to an ultrasonic sensor including a piezoelectric element.

### BACKGROUND ART

A general ultrasonic sensor provides a unimorph structure by bonding a piezoelectric element to an inner surface of a bottom portion of a case composed of a metal, and transmits and receives ultrasonic waves by causing bending vibration of the bottom portion of the metal case. It should be noted that WO 2008/038683 (Patent Document 1) discloses a fuel injection system including a multilayer piezoelectric element, although a technical field thereof is different from that of the ultrasonic sensor. Further devices are known from JP 01-270499 A, JP 64-077299 A, JP 2010-069618 A, US 6 575 565 B1, JP 8-173416 A, JP 62-91857 A and JP 2002-301037 A.

### CITATION LIST

### PATENT DOCUMENT

PTD 1: WO 2008/038683

### SUMMARY OF INVENTION

### TECHNICAL PROBLEM

In an ultrasonic sensor including a general multilayer piezoelectric element, as the number of layers in the piezoelectric element is larger, sound pressure is increased during transmission of waves; however, sensitivity is decreased during reception of waves. In contrast, as the number of layers in the piezoelectric element is smaller, the sound pressure is decreased during transmission of waves; however, the sensitivity is increased during reception of waves. In such an ultrasonic sensor including the general multilayer piezoelectric element, a portion of the piezoelectric element for transmission of waves and a portion thereof for reception of waves are constituted of the same member. Accordingly, the sound pressure and the sensitivity are increased/decreased in a substantially reverse proportion depending on the number of layers in the piezoelectric element.

As result of diligent study, the inventors of the present application have obtained the following knowledge. Specifically, a reception electrode and a transmission electrode are connected to a piezoelectric element and a common electrode is disposed to face them both. According to a three-terminal structure constituted of the reception electrode, the transmission electrode, and the common electrode, a transmission region and a reception region are formed adjacent to each other in a plane direction of a bottom portion of a metal case. Since the transmission region and the reception region are formed independent of each other, the sound pressure during transmission and the sensitivity during reception can be adjusted independently.

However, it has been also found that: when such a three-terminal structure is employed, i.e., when the transmission region and the reception region adjacent to each other in the plane direction of the bottom portion of the metal case are formed in the piezoelectric element, folding (a phenomenon of a piezoelectric layer being partially winding) is likely to be caused during production of the piezoelectric element, disadvantageously.

The present invention has an object to provide an ultrasonic sensor having a configuration capable of suppressing occurrence of folding in the piezoelectric element even when a transmission region and a reception region are formed adjacent to each other in a plane direction of a bottom portion of a metal case.

### SOLUTION TO PROBLEM

An ultrasonic sensor according to an aspect of the present invention includes: a case having a bottom portion; and a piezoelectric element bonded to an inner surface of the bottom portion and configured to undergo bending vibration together with the bottom portion. The piezoelectric element includes: a piezoelectric layer including a transmission region, a reception region, and an isolation region; a common electrode having a shape extending across both the transmission region and the reception region; a transmission electrode facing the common electrode with the transmission region being interposed therebetween; and a reception electrode facing the common electrode with the reception region being interposed therebetween. The transmission region and the reception region are formed at positions adjacent to each other with the isolation region being interposed therebetween in a surface direction of the inner surface of the bottom portion. The transmission region includes one first constituent piezoelectric layer or a plurality of first constituent piezoelectric layers layered in a direction of being further away from the bottom portion, the plurality of first constituent piezoelectric layers being electrically connected in parallel. The reception region includes one second constituent piezoelectric layer or a plurality of second constituent piezoelectric layers layered in the direction of being further away from the bottom portion, the plurality of second constituent piezoelectric layers being electrically connected in parallel. The number of the one or the plurality of first constituent piezoelectric layers included in the transmission region is different from the number of the one or the plurality of second constituent piezoelectric layers included in the reception region. One or a plurality of float electrodes are provided in one of the transmission region and the reception region, the one of the transmission region and the reception region having a smaller number of layers.

Preferably, the number of the first constituent piezoelectric layers included in the transmission region is larger than the number of the one or the plurality of second constituent piezoelectric layers included in the reception region, and the float electrode is provided in the reception region.

Preferably, the float electrode is provided also in the isolation region. Preferably, the float electrode is provided to extend into the isolation region.

Preferably, the plurality of float electrodes are provided at positions in plane-symmetry with respect to a plane extending through a center of the piezoelectric element in a layering direction of the piezoelectric element.

Preferably, the plurality of float electrodes are disposed at an interval therebetween in a layering direction of the piezoelectric element, and both end portions of the float electrode furthest away from the bottom portion in the layering direction of the piezoelectric element are located inwardly of positions of the both end portions of the other float electrodes.

Preferably, the float electrode includes a facing portion located between a center of the piezoelectric element in a layering direction of the piezoelectric element and the bottom portion, and the facing portion faces at least one of the transmission electrode and the common electrode in the layering direction of the piezoelectric element.

Preferably, an interval between an inner electrode of the transmission electrode and the float electrode adjacent to each other with the isolation region being interposed therebetween is wider than an interval between an inner electrode of the common electrode and the float electrode adjacent to each other with the isolation region being interposed therebetween in the surface direction of the inner surface of the bottom portion.

An ultrasonic sensor according to another aspect of the present invention includes: a case having a bottom portion; and a piezoelectric element bonded to an inner surface of the bottom portion and configured to undergo bending vibration together with the bottom portion. The piezoelectric element includes: a piezoelectric layer including a transmission region, a reception region, and an isolation region; a common electrode having a shape extending across both the transmission region and the reception region; a transmission electrode facing the common electrode with the transmission region being interposed therebetween; and a reception electrode facing the common electrode with the reception region being interposed therebetween. The transmission region and the reception region are formed at positions adjacent to each other with the isolation region being interposed therebetween in a surface direction of the inner surface of the bottom portion. The transmission region includes one first constituent piezoelectric layer or a plurality of first constituent piezoelectric layers layered in a direction of being further away from the bottom portion, the plurality of first constituent piezoelectric layers being electrically connected in parallel. The reception region includes one second constituent piezoelectric layer or a plurality of second constituent piezoelectric layers layered in the direction of being further away from the bottom portion, the plurality of second constituent piezoelectric layers being electrically connected in parallel. The number of the one or the plurality of first constituent piezoelectric layers included in the transmission region is different from the number of the one or the plurality of second constituent piezoelectric layers included in the reception region. One or a plurality of float electrodes are provided in the isolation region.

Preferably, the piezoelectric element has the plurality of float electrodes, and at least one of the plurality of float electrodes has a thickness thicker than a thickness of the transmission electrode.

### ADVANTAGEOUS EFFECTS OF INVENTION

When producing the piezoelectric element having the configuration above, movement of the piezoelectric from the one with the larger number of constituent piezoelectric layers (volume) toward the other with the smaller number of constituent piezoelectric layers is suppressed due to the existence of the float electrode. Hence, even when the transmission region and the reception region are formed adjacent to each other in the plane direction of the bottom portion of the metal case, folding can be suppressed from occurring in the piezoelectric element.

### BRIEF DESCRIPTION OF DRAWINGS

Fig. 1 shows a functional block of a sensor device including an ultrasonic sensor in a reference art.
Fig. 2 is a cross sectional view showing the ultrasonic sensor in the reference art.
Fig. 3 is a plan view showing a piezoelectric element and an FPC included in the ultrasonic sensor in the reference art.
Fig. 4 is a plan view showing the piezoelectric element (in a state in which the FPC is detached) included in the ultrasonic sensor in the reference art.
Fig. 5 is a perspective view showing the piezoelectric element included in the ultrasonic sensor in the reference art.
Fig. 6 is a perspective view showing the piezoelectric element included in the ultrasonic sensor and the internal structure thereof in the reference art.
Fig. 7 is a perspective view showing electrodes included in the piezoelectric element of the ultrasonic sensor in the reference art.
Fig. 8 is a cross sectional view taken along a line VIII-VIII in Fig. 4.
Fig. 9 is a cross sectional view taken along a line IX-IX in Fig. 4.
Fig. 10 is a cross sectional view taken along a line X-X in Fig. 4.
Fig. 11 is cross sectional view for illustrating a method of producing the piezoelectric element included in the ultrasonic sensor in the reference art.
Fig. 12 is a cross sectional view showing how the piezoelectric element included in the ultrasonic sensor in the reference art is pressed in a pressing step.
Fig. 13 is a cross sectional view showing a piezoelectric element included in an ultrasonic sensor in a first embodiment.
Fig. 14 shows a cross sectional configuration in a layer provided with each of float electrodes 71, 73, 75, 77 in the piezoelectric element included in the ultrasonic sensor in the first embodiment.
Fig. 15 shows a cross sectional configuration in a layer provided with each of float electrodes 72, 74, 76 in the piezoelectric element included in the ultrasonic sensor in the first embodiment.
Fig. 16 is a cross sectional view showing a piezoelectric element included in an ultrasonic sensor in a second embodiment.
Fig. 17 shows a cross sectional configuration in a layer provided with an intermediate portion 23 of an electrode 20 in the piezoelectric element included in the ultrasonic sensor in the second embodiment.
Fig. 18 shows a cross sectional configuration in a layer provided with float electrodes 72, 76 in the piezoelectric element included in the ultrasonic sensor in the second embodiment.
Fig. 19 shows a cross sectional configuration in a layer provided with each of a float electrode 74 in the piezoelectric element included in the ultrasonic sensor in the second embodiment.
Fig. 20 is a cross sectional view showing a piezoelectric element included in an ultrasonic sensor in a third embodiment.
Fig. 21 shows a cross sectional configuration in a layer provided with an intermediate portion 23 of an electrode 20 in the piezoelectric element included in the ultrasonic sensor in the third embodiment.
Fig. 22 shows a cross sectional configuration in a layer provided with a float electrode 76 in the piezoelectric element included in the ultrasonic sensor in the third embodiment.
Fig. 23 shows a cross sectional configuration in a layer provided with a float electrode 74 in the piezoelectric element included in the ultrasonic sensor in the third embodiment.
Fig. 24 shows a cross sectional configuration in a layer provided with a float electrode 72 in the piezoelectric element included in the ultrasonic sensor in the third embodiment.
Fig. 25 illustrates experiment examples for the reference art (comparative example) and the first to third embodiments.
Fig. 26 is a cross sectional view showing a piezoelectric element included in an ultrasonic sensor in a fourth embodiment.
Fig. 27 is a cross sectional view showing a piezoelectric element included in an ultrasonic sensor in a fifth embodiment.
Fig. 28 is a cross sectional view showing a piezoelectric element included in an ultrasonic sensor in a sixth embodiment.
Fig. 29 is a cross sectional view showing a piezoelectric element included in an ultrasonic sensor in a seventh embodiment.
Fig. 30 is a cross sectional view showing a piezoelectric element included in an ultrasonic sensor in an eighth embodiment.

### DESCRIPTION OF EMBODIMENTS

### [Reference Art]

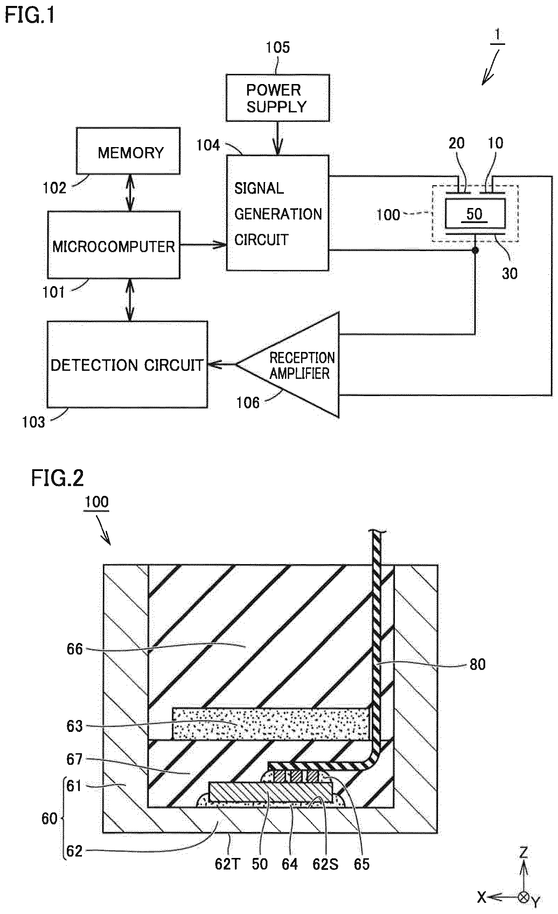

Before describing embodiments according to the present invention, the following first describes an ultrasonic sensor 100 in a reference art with reference to Fig. 1 to Fig. 10. In the description of the reference art, the same and corresponding components are given the same reference characters and may not be described repeatedly.

Fig. 1 shows a functional block of a sensor device 1 including ultrasonic sensor 100 in the reference art. Sensor device 1 includes ultrasonic sensor 100, a microcomputer 101, a memory 102, a detection circuit 103, a signal generation circuit 104, a power supply 105, and a reception amplifier 106. Ultrasonic sensor 100 includes a piezoelectric element 50, which has a three-terminal structure constituted of electrodes 10, 20, 30.

Microcomputer 101 reads data stored in memory 102, and outputs a control signal to signal generation circuit 104. Based on the control signal, signal generation circuit 104 generates AC voltage from DC voltage. The AC voltage is supplied to ultrasonic sensor 100, and ultrasonic waves are transmitted into air or the like from ultrasonic sensor 100. When ultrasonic sensor 100 receives a reflected wave from a target, a reception signal generated in ultrasonic sensor 100 is sent to the reception amplifier 106 as a voltage value, and is sent to microcomputer 101 through detection circuit 103. Information related to presence or absence and movement of the target can be known through microcomputer 101.

### (Ultrasonic Sensor 100)

Fig. 2 is a cross sectional view showing ultrasonic sensor 100 in the reference art. Ultrasonic sensor 100 includes a piezoelectric element 50, a case 60, a sound absorbing material 63, an adhesive agent 64, a bonding agent 65, silicones 66, 67, and a FPC (flexible printed circuit) 80. Case 60 has a cylindrical shape with a bottom. Case 60 is composed of aluminum that has high elasticity and is lightweight, for example. Case 60 is produced by forging or cutting such aluminum, for example.

Case 60 includes: a bottom portion 62 having a disk-like shape; and a cylindrical portion 61 provided along a peripheral edge of bottom portion 62 and having a cylindrical shape. Bottom portion 62 has an inner surface 62S and an outer surface 62T. Piezoelectric element 50 is composed of a lead zirconate titanate based ceramic, for example. Piezoelectric element 50 is disposed on inner surface 62S of bottom portion 62 and is bonded to inner surface 62S using adhesive agent 64. Adhesive agent 64 is an epoxy adhesive agent, for example. When ultrasonic sensor 100 is driven, piezoelectric element 50 undergoes bending vibration together with bottom portion 62.

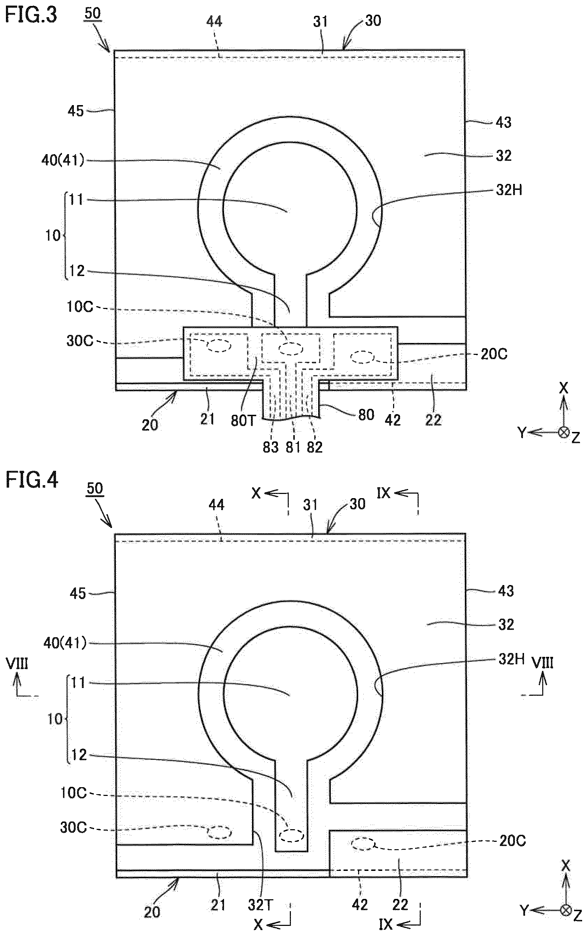

Piezoelectric element 50 includes three electrodes (not shown) (corresponding to electrodes 10 to 30 in Fig. 1, and details thereof will be described later). As shown in Fig. 3, a leading end portion 80T of FPC 80 has a T shape. FPC 80 is electrically bonded to these electrodes with bonding agent 65 interposed therebetween. A resin material having a metal added therein is used as bonding agent 65, for example. A portion of FPC 80 opposite to a portion thereof bonded to the piezoelectric element 50 is extended to the outside of case 60 and is electrically connected to signal generation circuit 104 (Fig. 1), reception amplifier 106 (Fig. 1), and the like.

### (Piezoelectric Element 50)

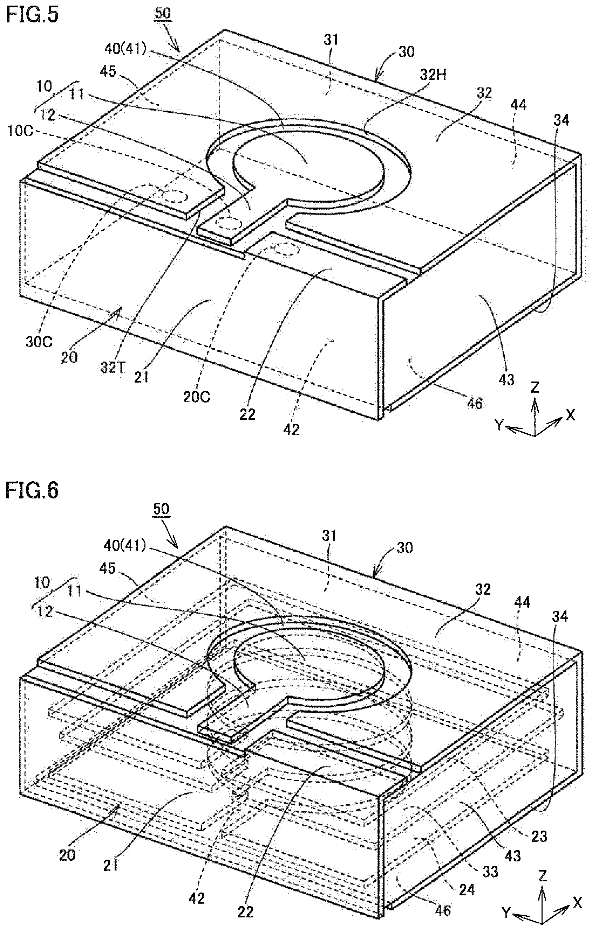

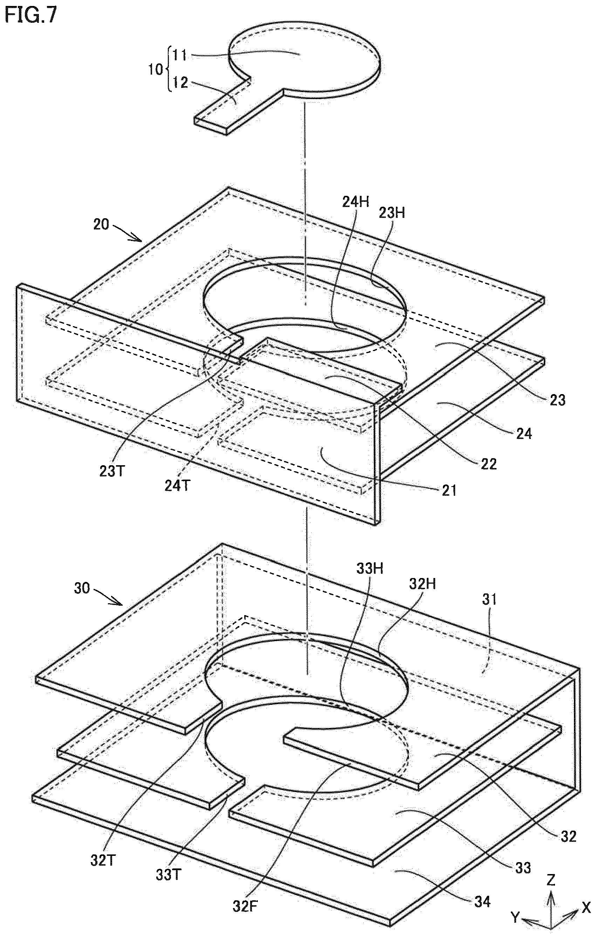

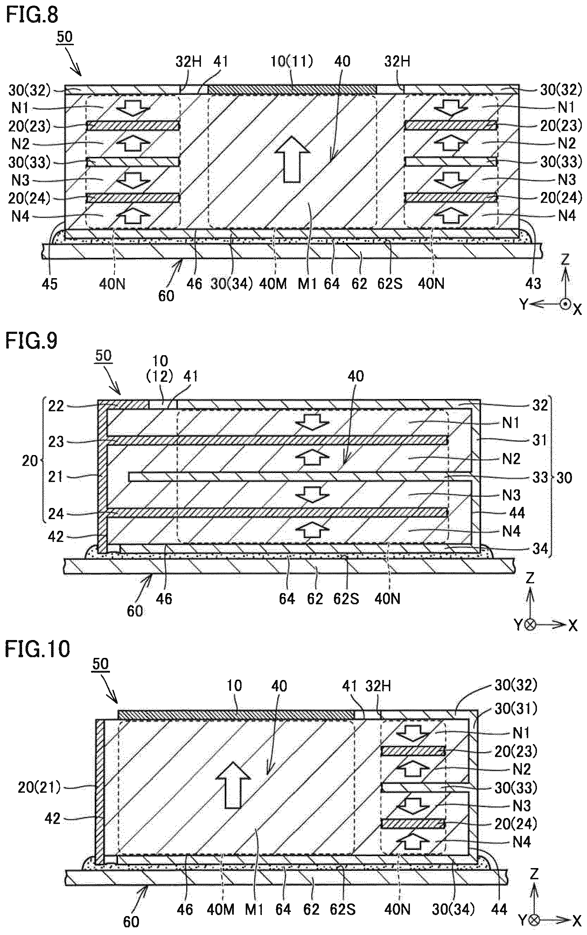

Fig. 3 is a plan view showing piezoelectric element 50 and FPC 80. Fig. 4 is a plan view showing piezoelectric element 50 (in a state in which FPC 80 is detached). Fig. 5 is a perspective view showing piezoelectric element 50. Fig. 6 is a perspective view showing piezoelectric element 50 and the internal structure thereof. Fig. 7 is a perspective view showing electrodes 10, 20, 30 included in piezoelectric element 50. Fig. 8 is a cross sectional view taken along a line VIII-VIII in Fig. 4. Fig. 9 is a cross sectional view taken along a line IX-IX in Fig. 4. Fig. 10 is a cross sectional view taken long a line X-X in Fig. 4.

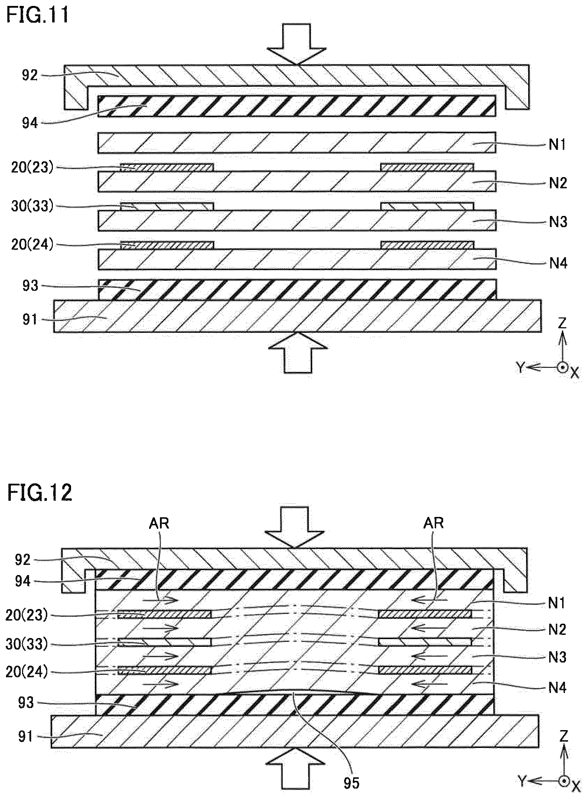

In Fig. 3 to Fig. 10, arrows X, Y, Z are indicated for convenience of description. Arrows X, Y, Z are orthogonal to one another. Hereinafter, the respective configurations of piezoelectric element 50 may be described with reference to arrows X, Y, Z. However, positional relations of the respective configurations (characteristics related to orthogonality and parallelism) are not necessarily limited to the positional relations indicated by arrows X, Y, Z. The same applies to Fig. 11 to Fig. 24 and Fig. 26 to Fig. 29 below.

As shown in Fig. 3 to Fig. 10, piezoelectric element 50 includes a piezoelectric layer 40 (Fig. 3 to Fig. 6 and Fig. 8 to Fig. 19), electrode 10 (Fig. 7), electrode 20 (Fig. 7), and electrode 30 (Fig. 7). Piezoelectric layer 40 has a substantially rectangular parallelepiped outer shape (see Fig. 5 and Fig. 6) and piezoelectric layer 40 has an upper surface 41, side surfaces 42 to 45, and a lower surface 46.

Upper surface 41 is a surface of piezoelectric layer 40 located at the arrow Z direction side. Lower surface 46 is a surface of piezoelectric layer 40 located at a side opposite to the arrow Z direction. Side surfaces 42, 44 are surfaces of piezoelectric layer 40 orthogonal to the arrow X direction and facing each other. Side surfaces 43, 45 are surfaces of piezoelectric layer 40 orthogonal to the arrow Y direction and facing each other.

### (Electrode 10 (Reception Electrode))

Electrode 10 includes a disk portion 11 and an extending portion 12 (see Fig. 7). Electrode 10 serves as a "reception electrode". Extending portion 12 has a shape extending outwardly from the outer edge of disk portion 11. Extending portion 12 is disposed to extend from the side at which disk portion 11 is located toward the side at which side surface 42 of piezoelectric layer 40 is located. As shown in Fig. 3, electrode 10 and FPC 80 (wiring pattern 81) are electrically connected at a portion (connection position 10C) between wiring pattern 81 provided in FPC 80 and extending portion 12 of electrode 10 (also see Fig. 4 and Fig. 5).

### (Electrode 20 (Transmission Electrode))

Electrode 20 includes a side wall portion 21, an upper surface portion 22, and intermediate portions 23, 24 (see Fig. 7). Electrode 20 serves as a "transmission electrode". Side wall portion 21 faces side surface 42 (Fig. 5) of piezoelectric layer 40 and is in contact with side surface 42. Upper surface portion 22 is provided continuous to an end portion of side wall portion 21 at the arrow Z direction side, and is disposed on upper surface 41 of piezoelectric layer 40. Intermediate portions 23, 24 are portions of electrode 20 inside piezoelectric layer 40, and are not visually recognized in a state in which piezoelectric element 50 is completed (see Fig. 5). An intermediate portion 33 of electrode 30 is disposed between intermediate portion 23 and intermediate portion 24 (see Fig. 8 to Fig. 10, and the like).

In intermediate portion 23, a hollowed portion 23H (Fig. 7) and a cutout portion 23T are provided. In intermediate portion 24, a hollowed portion 24H (Fig. 7) and a cutout portion 24T are provided. As shown in Fig. 7 and Fig. 9, end portions of intermediate portions 23, 24 in the direction opposite to arrow X are connected to side wall portion 21. On the other hand, end portions of intermediate portions 23, 24 in the arrow X direction are not connected to a side wall portion 31 of electrode 30 (described below) and are separated from side wall portion 31. As shown in Fig. 3, electrode 20 and FPC 80 (wiring pattern 82) are electrically connected at a portion (connection position 20C) between wiring pattern 82 provided in FPC 80 and upper surface portion 22 of electrode 20 (also see Fig. 4 and Fig. 5).

### (Electrode 30 (Common Electrode))

Electrode 30 includes side wall portion 31, an upper surface portion 32, intermediate portion 33, and a lower surface portion 34 (see Fig. 7). Electrode 30 serves as a "common electrode". Side wall portion 31 faces side surface 44 (Fig. 5) of piezoelectric layer 40 and is in contact with side surface 44. Lower surface portion 34 faces lower surface 46 of piezoelectric layer 40 and is in contact with lower surface 46. Upper surface portion 32 is provided continuous to an end portion of side wall portion 31 at the arrow Z direction side, and is disposed on upper surface 41 of piezoelectric layer 40. Intermediate portion 33 is a portion of electrode 30 inside piezoelectric layer 40, and is not visually recognized in the state in which piezoelectric element 50 is completed (see Fig. 5).

Hollowed portions 32H, 33H (Fig. 7) are provided in upper surface portion 32 and intermediate portion 33, respectively. Disk portion 11 of electrode 10 is disposed in hollowed portion 32H (see Fig. 5). Cutout portions 32T, 33T are also provided in upper surface portion 32 and intermediate portion 33, respectively. Extending portion 12 of electrode 10 is disposed within cutout portion 32T (see Fig. 5). A retracted portion 32F is provided at a portion of upper surface portion 32 in the direction opposite to arrow Y. Retracted portion 32F is a portion for permitting upper surface portion 22 of electrode 20 to be disposed.

As shown in Fig. 7 and Fig. 9, end portions of upper surface portion 32, intermediate portion 33, and lower surface portion 34 in the arrow X direction are connected to side wall portion 31. On the other hand, end portions of upper surface portion 32, intermediate portion 33, and lower surface portion 34 in the direction opposite to arrow X are not connected to side wall portion 21 of electrode 20 and are separated from side wall portion 21. As shown in Fig. 3, electrode 30 and FPC 80 (wiring pattern 83) are electrically connected at a portion (connection position 30C) between wiring pattern 83 provided in FPC 80 and upper surface portion 32 of electrode 30 (also see Fig. 4 and Fig. 5).

### (Transmission Region and Reception Region)

With reference to Fig. 8 to Fig. 10, a transmission region 40N and a reception region 40M are formed in piezoelectric layer 40. Transmission region 40N has a four-layer structure constituted of first constituent piezoelectric layers N1 to N4. First constituent piezoelectric layers N1 to N4 are layered in a direction of being further away from bottom portion 62 of case 60 and are electrically connected in parallel by electrode 20 and electrode 30. White arrows in Fig. 8 to Fig. 10 indicate polarization directions of the respective piezoelectric layers. On the other hand, reception region 40M has a one-layer structure constituted of a second constituent piezoelectric layer M1.

Lower surface portion 34 of electrode 30 has a shape extending across both transmission region 40N and reception region 40M. Upper surface portion 22 of electrode 20 faces lower surface portion 34 of electrode 30 with transmission region 40N including first constituent piezoelectric layers N1 to N4 being interposed therebetween. Disk portion 11 of electrode 10 faces lower surface portion 34 of electrode 30 with reception region 40M including second constituent piezoelectric layer M1 being interposed therebetween.

Specifically, the following regions serve as transmission region 40N in piezoelectric layer 40: a region located between upper surface portion 22 of electrode 20 and lower surface portion 34 of electrode 30; a region located between intermediate portion 23 of electrode 20 and upper surface portion 32 of electrode 30; and a region located between intermediate portion 23 of electrode 20 and lower surface portion 34 of electrode 30. On the other hand, a region between disk portion 11 of electrode 10 and lower surface portion 34 of electrode 30 in piezoelectric layer 40 serves as reception region 40M. As shown in Fig. 8 and Fig. 10, transmission region 40N and reception region 40M are formed at positions adjacent to each other in a surface direction (X-Y plane direction) of inner surface 62S of bottom portion 62 of case 60. Specifically, reception region 40M is provided at the central portion of piezoelectric layer 40, and transmission region 40N is provided at a peripheral portion radially outwardly of reception region 40M so as to surround reception region 40M.

With reference to Fig. 11, when producing piezoelectric element 50, resin sheets 93, 94 are disposed between a lower frame 91 and an upper frame 92. Between resin sheets 93, 94, four piezoelectric layers (ceramic sheets) each constituted of a thin piezoelectric ceramic and having a rectangular shape are disposed. For the portions of first constituent piezoelectric layers N1 to N4 constituting transmission region 40N, the four piezoelectric layers are layered with intermediate portion 23 of electrode 20, intermediate portion 33 of electrode 30, and intermediate portion 24 of electrode 20 being disposed therebetween. For the portion of second constituent piezoelectric layer M1 constituting reception region 40M, the four piezoelectric layers are layered with no electrode being disposed therebetween. Piezoelectric element 50 is produced by performing a pressing step of pressing them from above and below, a degreasing process, and a calcinating step.

Fig. 12 is a cross sectional view showing how piezoelectric element 50 is pressed in the pressing step. Each of the piezoelectric layers before calcination is soft and has flexibility. While the four piezoelectric layers are pressed, portions around electrode 20 (intermediate portion 23), electrode 30 (intermediate portion 33), and electrode 20 (intermediate portion 24) in the piezoelectric layers are pressed with loads larger than loads on other portions by the thicknesses of these inner electrodes. Since each of the piezoelectric layers before calcination is soft, the piezoelectric layer before calcination is pushed out to move in a direction in which no inner electrode exists (in a direction indicated by arrows AR). This may result in occurrence of folding at and around the portion constituting reception region 40M (see Fig. 8). If a recess 95 (Fig. 12) is formed in piezoelectric layer 40 due to the folding, piezoelectric element 50 is less likely to be appropriately bonded to case 60. This may result in adhesion failure and decreased sensitivity.

### [Embodiments]

The following describes embodiments and examples based on the present invention with reference to figures. When the number and an amount of components are referred, the scope of the present invention is not necessarily limited to the number and the amount of them unless otherwise specified. The same and corresponding components are given the same reference characters and may not be described repeatedly. It should be noted that in the below description of the embodiments, a difference between each embodiment and the above-described reference art will be mainly described and the same explanation may not be repeatedly described.

### [First Embodiment]

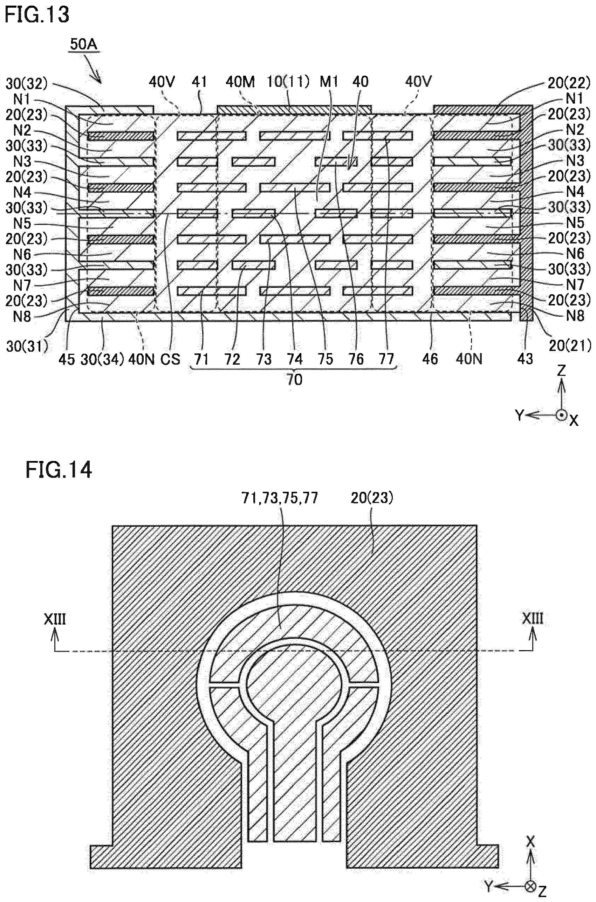

Fig. 13 is a cross sectional view showing a piezoelectric element 50A in the first embodiment. Fig. 13 corresponds to Fig. 8 in the above-described reference art. Fig. 14 shows a cross sectional configuration in a layer (height position) provided with a float electrode 71 in piezoelectric element 50A. This cross sectional view is drawn in the same manner as cross sectional configurations in layers (height positions) provided with float electrodes 73, 75, 77 of piezoelectric element 50A. Therefore, in Fig. 14, they are collectively drawn as one figure.

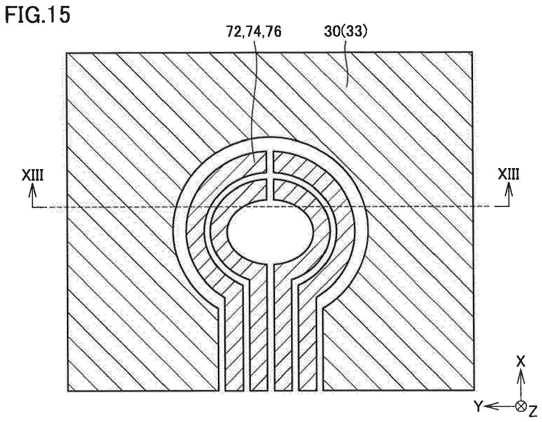

Fig. 15 shows a cross sectional configuration in a layer (height position) provided with a float electrode 72 in piezoelectric element 50A. This cross sectional view is drawn in the same manner as cross sectional configurations in layers (height positions) provided with float electrodes 74, 76 of piezoelectric element 50A. Therefore, in Fig. 15, they are collectively drawn as one figure. Fig. 13 corresponds to a cross sectional view at a position of a XIII-XIII line in each of Fig. 14 and Fig. 15.

Piezoelectric element 50A in the present embodiment is incorporated in a case 60 (see Fig. 2) in the same manner as piezoelectric element 50 in the above-described reference art. Specifically, an ultrasonic sensor in the present embodiment includes: case 60 (Fig. 2) having a bottom portion 62; and piezoelectric element 50A bonded to an inner surface 62S of bottom portion 62 and configured to undergo bending vibration together with bottom portion 62.

### (Piezoelectric Element 50A)

As shown in Fig. 13 to Fig. 15, piezoelectric element 50A includes a piezoelectric layer 40, electrodes 10 to 30, and float electrodes 70 (float electrodes 71 to 77). Piezoelectric layer 40 has a rectangular parallelepiped shape as with the above-described reference art. Fig. 13 illustrates an upper surface 41, side surfaces 43, 45, and a lower surface 46.

Electrode 10 (reception electrode) is formed on upper surface 41 of piezoelectric layer 40. Electrode 20 (transmission electrode) includes a side wall portion 21, an upper surface portion 22, and a plurality of intermediate portions 23. Side wall portion 21 faces side surface 43 of piezoelectric layer 40 and is in contact with side surface 43. Upper surface portion 22 is provided continuous to an end portion of side wall portion 21 at the arrow Z direction side, and is disposed on upper surface 41 of piezoelectric layer 40. The plurality of intermediate portions 23 are portions (inner electrodes) of electrode 20 inside piezoelectric layer 40, and are not visually recognized in a state in which piezoelectric element 50A is completed. Intermediate portions 33 of electrode 30 are disposed between the plurality of intermediate portions 23.

Electrode 30 (common electrode) includes a side wall portion 31, an upper surface portion 32, and the plurality of intermediate portions 33. Side wall portion 31 faces side surface 45 of piezoelectric layer 40 and is in contact with side surface 45. Upper surface portion 32 is provided continuous to an end portion of side wall portion 31 at the arrow Z direction side, and is disposed on upper surface 41 of piezoelectric layer 40. The plurality of intermediate portions 33 are portions (inner electrodes) of electrode 30 inside piezoelectric layer 40, and are not visually recognized in the state in which piezoelectric element 50A is completed. Intermediate portions 23 of electrode 20 are disposed between the plurality of intermediate portions 33.

### (Transmission Region and Reception Region)

A transmission region 40N, a reception region 40M, and an isolation region 40V are formed in piezoelectric layer 40. The number of layers in transmission region 40N constituted of one or a plurality of constituent piezoelectric layers is configured to be different from the number of layers in reception region 40M constituted of one or a plurality of constituent piezoelectric layers. In the embodiment, transmission region 40N has an eight-layer structure constituted of first constituent piezoelectric layers N1 to N8. On the other hand, reception region 40M has a one-layer structure constituted of a second constituent piezoelectric layer M1.

First constituent piezoelectric layers N1 to N8 are layered in a direction of being further away from bottom portion 62 of case 60 (Fig. 2). Moreover, first constituent piezoelectric layers N1 to N8 are electrically connected in parallel by upper surface portion 22 and intermediate portions 23 of electrode 20 (transmission electrode) and upper surface portion 32 and intermediate portions 33 of electrode 30 (common electrode).

Lower surface portion 34 of electrode 30 has a shape extending across both transmission region 40N and reception region 40M adjacent to each other with isolation region 40V being interposed therebetween. Upper surface portion 22 of electrode 20 faces lower surface portion 34 of electrode 30 with transmission region 40N including first constituent piezoelectric layers N1 to N8 being interposed therebetween. Electrode 10 faces lower surface portion 34 of electrode 30 with reception region 40M including second constituent piezoelectric layer M1 being interposed therebetween.

In piezoelectric layer 40, the following regions serve as transmission region 40N: a region located between upper surface portion 22 of electrode 20 and lower surface portion 34 of electrode 30; a region located between intermediate portion 23 of electrode 20 and upper surface portion 32 of electrode 30; and a region located between intermediate portion 23 of electrode 20 and lower surface portion 34 of electrode 30. A region located between electrode 10 and lower surface portion 34 of electrode 30 serves as reception region 40M. Transmission region 40N and reception region 40M are formed at positions adjacent to each other with isolation region 40V (insulating region) interposed therebetween in a surface direction (X-Y plane direction) of inner surface 62S of bottom portion 62 of case 60. Specifically, reception region 40M is provided at a center portion of piezoelectric layer 40. Although Fig. 13 illustrates as if there were a plurality of transmission regions 40N, they are continuously connected to each other and transmission region 40N is provided on a peripheral portion radially outwardly of reception region 40M so as to surround reception region 40M.

### (Float Electrode 70)

Float electrodes 70 are provided in one of transmission region 40N and reception region 40M, the one of transmission region 40N and reception region 40M having a smaller number of constituent piezoelectric layers. Since transmission region 40N is constituted of eight first constituent piezoelectric layers and reception region 40M is constituted of one second constituent piezoelectric layer in the present embodiment, the plurality of float electrodes 70 (float electrodes 71 to 77) are provided in second constituent piezoelectric layer M1 at an interval therebetween in the layering direction of piezoelectric element 50.

Float electrodes 70 (also referred to as dummy electrodes) are electrically connected to none of electrodes 10 to 30, and are entirely surrounded by piezoelectric layer 40. The plurality of float electrodes 70 can be formed together with intermediate portions 23 of electrode 20 or intermediate portions 33 of electrode 30 by a printing method or the like in the same step using a masking process or the like. As shown in Fig. 14, each of float electrodes 71, 73, 75, 77 is divided into four regions, and Fig. 13 shows cross sectional shapes of three of these regions. As shown in Fig. 15, each of float electrodes 72, 74, 76 is also divided into four regions, and Fig. 13 shows cross sectional shapes of the four regions.

In the present embodiment, between upper surface portion 22 of electrode 20 and lower surface portion 34 of electrode 30, in other words, between upper surface portion 32 of electrode 30 and lower surface portion 34 of electrode 30, seven inner electrodes (intermediate portions 23 of electrode 20 and intermediate portions 33 of electrode 30) in total are provided. On the other hand, in second constituent piezoelectric layer M1, float electrodes 71 to 77 as many as the inner electrodes, i.e., seven float electrodes 71 to 77 are provided. Each of the inner electrodes (intermediate portions 23 of electrode 20 and intermediate portions 33 of electrode 30) is provided at the same height as that of a corresponding one of float electrodes 71 to 77.

Electrode 10 (reception electrode), upper surface portion 22 of electrode 20, upper surface portion 32 of electrode 30, and lower surface portion 34 of electrode 30 are formed by sputtering or vapor deposition using a mask in a step different from the step in which the inner electrodes (intermediate portions 23 of electrode 20 and intermediate portions 23 of electrode 30) are formed.

### (Function and Effect)

As described at the beginning of the specification, the conventional ultrasonic sensor exhibits such characteristics that: as the number of layers in the piezoelectric element is larger, the sound pressure is increased during transmission of waves but the sensitivity is decreased during reception of waves. This is because the portion of the piezoelectric element for transmission of waves and the portion thereof for reception of waves are constituted of the same member in the conventional multilayer piezoelectric element.

In the present embodiment, the portion (transmission region 40N) of piezoelectric element 50A for transmission of waves and the portion (reception region 40M) thereof for reception of waves are formed to be separated from each other. For the portion (transmission region 40N) of piezoelectric element 50A for transmission of waves, the eight-layer structure is employed in order to increase the sound pressure during transmission of waves, whereas the one-layer structure is still employed for the portion (reception region 40M) thereof for reception of waves. The ultrasonic sensor in the present embodiment is suppressed from being decreased in sensitivity during reception of waves, as compared with the conventional configuration. Therefore, it can be said that the ultrasonic sensor of the present embodiment has a configuration capable of independently adjusting both the sound pressure during transmission and the sensitivity during reception.

With reference to Fig. 12, as described above, the plurality of piezoelectric layers (ceramic sheets) before calcination are soft and have flexibility. If there are no float electrodes 71 to 77, portions near electrode 20 (intermediate portion 23), electrode 30 (intermediate portion 33), and electrode 20 (intermediate portion 24) in the piezoelectric layers are pressed with loads larger than loads on the other portions by the thicknesses of these inner electrodes when the eight piezoelectric layers are pressed.

On the other hand, in the present embodiment, float electrodes 71 to 77 serve to reduce the difference in thickness (difference in load) resulting from the existence of the inner electrodes. A difference becomes smaller than that in the reference art between the loads acting on the portions provided with the inner electrodes in the piezoelectric layer and the loads acting on the portions provided with float electrodes 71 to 77 in the piezoelectric layer. Therefore, although the soft piezoelectric layer is moved to expand in the in-plane direction, an amount of movement becomes smaller than that in the case of the reference art. As a result, folding is suppressed from occurring at and near the portion constituting reception region 40M (see Fig. 8). Piezoelectric element 50A can be appropriately bonded to inner surface 62S of bottom portion 62 of case 60 (Fig. 2), whereby improved adhesive property and sensitivity can be expected.

In the present embodiment, float electrodes 70 are not provided in transmission region 40N. In other words, float electrodes 71 to 77 do not face upper surface portion 22 and intermediate portions 23 of electrode 20 and do not face upper surface portion 22 and intermediate portions 33 of electrode 30. Increase in parasitic capacitance by providing float electrodes 71 to 77 is suppressed, and the sensitivity is hardly decreased.

In the present embodiment, a part of float electrodes 70 is provided to extend into isolation region 40V. Float electrodes 70 may be provided only in second constituent piezoelectric layer M1; however, in view of suppression of folding, it can be said desirable that float electrodes 70 are provided also in isolation region 40V. On the other hand, the existence of float electrodes 70 leads to increased rigidity of piezoelectric element 50A as well as increased residual stress of piezoelectric layer 40 after calcination.

If float electrodes 70 are provided more than necessary, the parasitic capacitance may be increased, piezoelectric element 50A may be less likely to undergo bending vibration, and a piezoelectric constant may be decreased. Therefore, in consideration of suppression of folding, increase in parasitic capacitance, increase in rigidity of piezoelectric element 50A, increase in piezoelectric constant of piezoelectric element 50A, and the like, an appropriate amount of float electrodes 70 are preferably provided in piezoelectric layer 40 at appropriate locations. In order to suppress the increase in rigidity (constraint of vibration) and the decrease in piezoelectric constant, float electrodes 71 to 77 can be suitably provided in a distributed manner at a plurality of positions within the same planes, as described in the present embodiment.

In the present embodiment, the plurality of float electrodes 71 to 77 are provided at positions in plane-symmetry with respect to a plane CS extending through the center of piezoelectric element 50A in the layering direction of piezoelectric element 50A. According to the configuration, when calcination is completed, shrinkage force (shrinkage force caused due to thermal contraction) in plane-symmetry with respect to plane CS is generated in piezoelectric layer 40, whereby calcinated piezoelectric element 50A can be suppressed from being warped.

### [Second Embodiment]

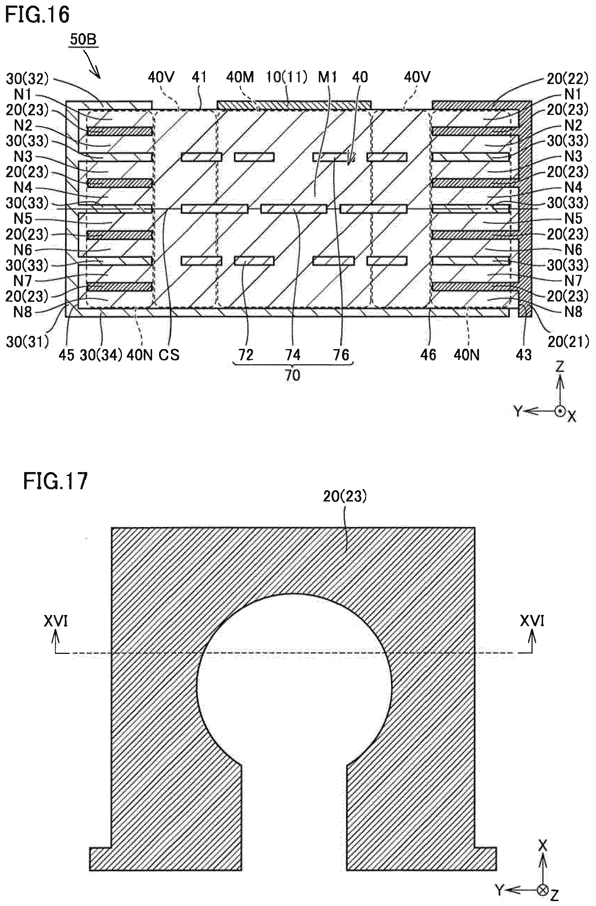

Fig. 16 is a cross sectional view showing a piezoelectric element 50B in a second embodiment. Fig. 16 corresponds to Fig. 8 in the above-described reference art. Fig. 17 shows a cross sectional configuration in a layer (height position) provided with an intermediate portion 23 of an electrode 20 in piezoelectric element 50B. Layers each provided with intermediate portion 23 of electrode 20 are drawn in the same manner. Therefore, Fig. 17 collectively illustrates them as one figure.

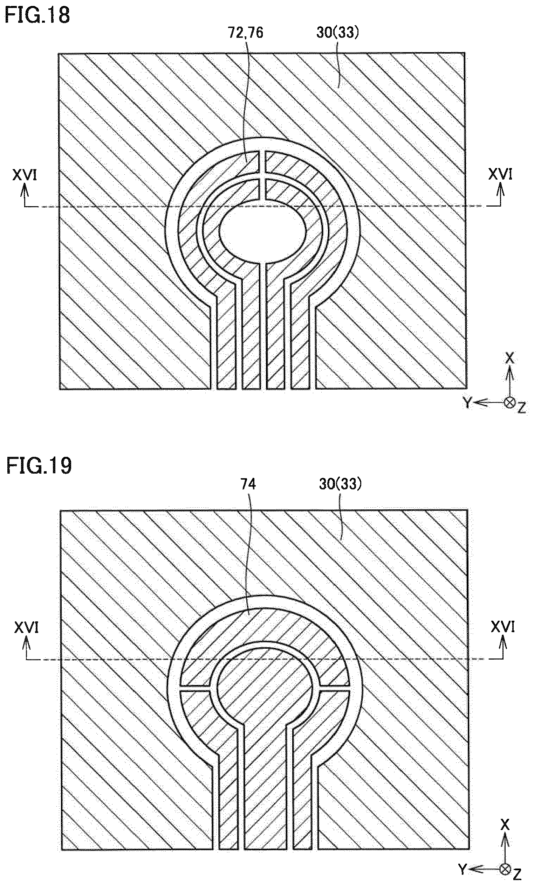

Fig. 18 shows a cross sectional configuration in a layer (height position) provided with a float electrode 72 in piezoelectric element 50B. This cross sectional view is drawn in the same manner as a cross sectional configuration in a layer (height position) provided with a float electrode 76 of piezoelectric element 50B. Therefore, Fig. 18 collectively illustrates them as one figure. Fig. 19 shows a cross sectional configuration in a layer (height position) provided with a float electrode 74 in piezoelectric element 50B. Fig. 16 corresponds to a cross sectional view at a position of an XVI-XVI line in each of Fig. 17 to Fig. 19.

As described above, if float electrodes 70 are provided more than necessary, the parasitic capacitance may be increased, piezoelectric element 50B may be less likely to undergo bending vibration, or the piezoelectric constant may be decreased. In the present embodiment, the number of float electrodes 70 is smaller than that in the first embodiment. This is more disadvantageous than the first embodiment in terms of suppression of folding, but is more advantageous in terms of increase in parasitic capacitance, a degree of bending vibration of piezoelectric element 50B, and decrease in piezoelectric constant. Since the plurality of float electrodes 72, 74, 76 are provided at positions in plane-symmetry with respect to plane CS extending through the center of piezoelectric element 50B in the layering direction of piezoelectric element 50B, calcinated piezoelectric element 50B can be suppressed from being warped.

### [Third Embodiment]

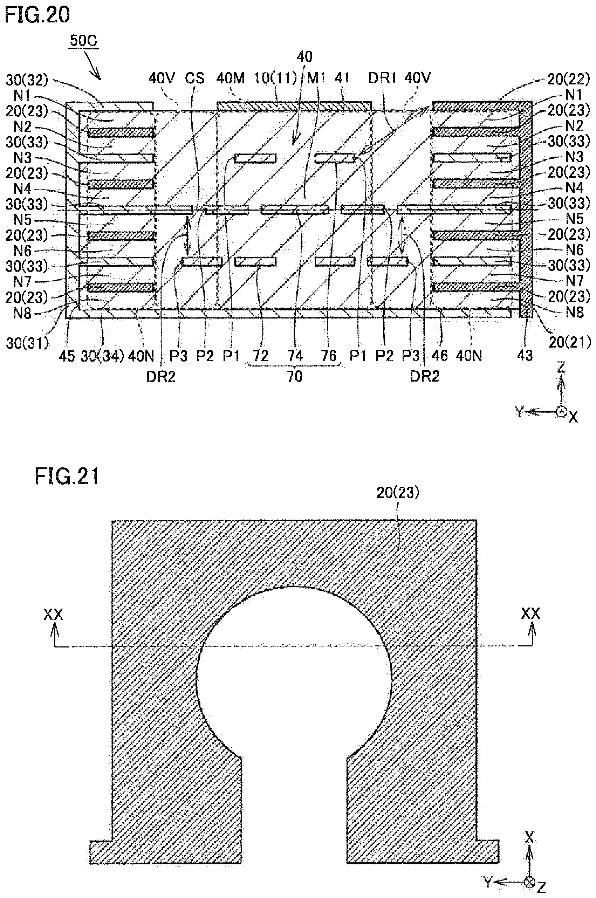

Fig. 20 is a cross sectional view showing a piezoelectric element 50C in a third embodiment. Fig. 20 corresponds to Fig. 8 in the above-described reference art. Fig. 21 shows a cross sectional configuration in a layer (height position) provided with an intermediate portion 23 of an electrode 20 in piezoelectric element 50C. Layers each provided with intermediate portion 23 of electrode 20 are drawn in the same manner. Therefore, Fig. 21 collectively illustrates them as one figure.

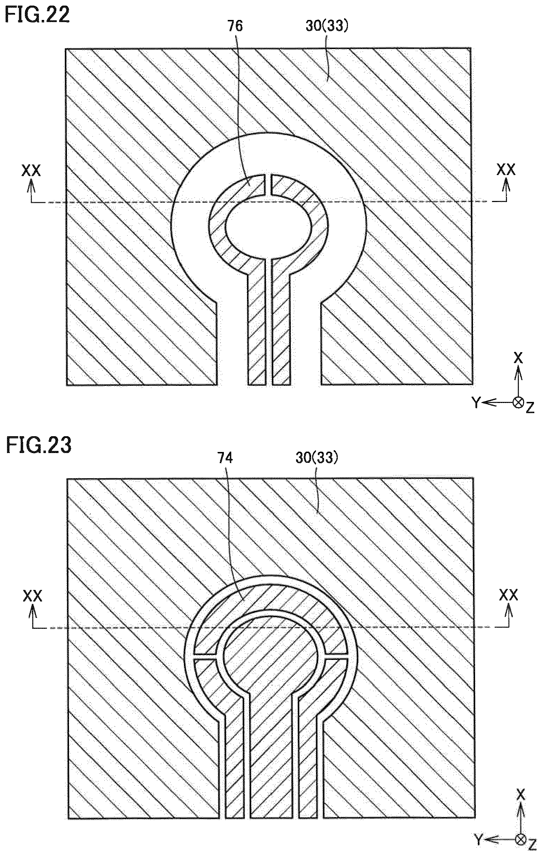

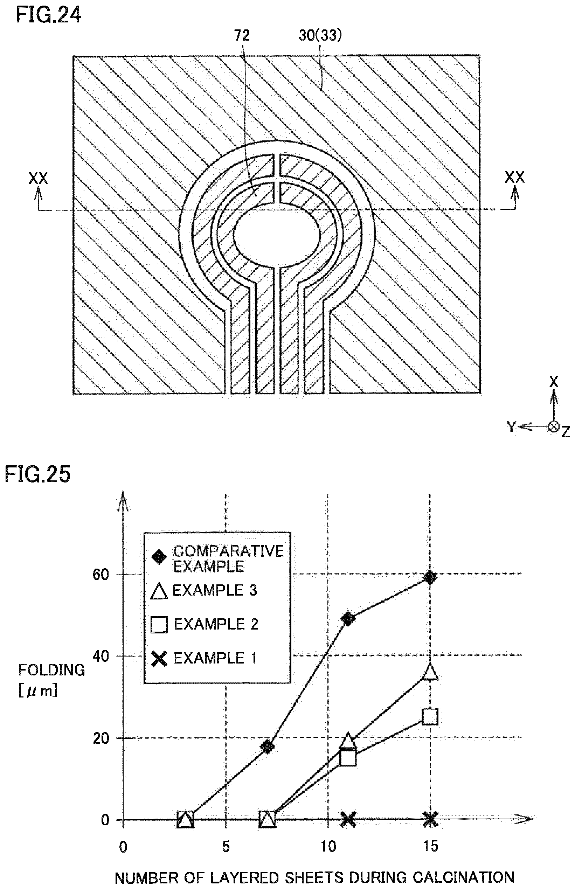

Fig. 22 shows a cross sectional configuration in a layer (height position) provided with a float electrode 76 in piezoelectric element 50C. Fig. 23 shows a cross sectional configuration in a layer (height position) provided with a float electrode 74 in piezoelectric element 50C. Fig. 24 shows a cross sectional configuration in a layer (height position) provided with a float electrode 72 in piezoelectric element 50C. Fig. 20 corresponds to a cross sectional view at a position of an XX-XX line in each of Fig. 21 to Fig. 24.

In the present embodiment, both end portions P1 of float electrode 76 furthest away from bottom portion 62 of case 60 (Fig. 2) in the layering direction of piezoelectric element 50C are located inwardly of the positions of both end portions P2 and both end portions P3 of the other float electrodes 72, 74. According to this configuration, a distance DR1 between both end portions P1 of float electrode 76 and upper surface portion 22 of electrode 20 can be longer than that in the second embodiment. The same applies to a distance between both end portions P1 of float electrode 76 and upper surface portion 32 of electrode 30.

As described above, electrode 10 (reception electrode), upper surface portion 22 of electrode 20, upper surface portion 32 of electrode 30, and lower surface portion 34 of electrode 30 are formed, by sputtering and vapor deposition using a mask, in a step different from that for the inner electrodes (intermediate portions 23 of electrode 20 and intermediate portions 23 of electrode 30). A relative position between both end portions P1 of float electrode 76 and upper surface portion 22 of electrode 20 may be deviated. Even if such positional deviation occurs, upper surface portion 22 of electrode 20 hardly faces float electrode 76 because long distance DR1 is secured, thereby suppressing increase in parasitic capacitance (decrease in sensitivity). The same applies to a relative position between both end portions P1 of float electrode 76 and upper surface portion 32 of electrode 30.

Moreover, in the present embodiment, a part of float electrode 72 serves as a "facing portion". Float electrode 72 is located between the center of piezoelectric element 50C (position of plane CS) and bottom portion 62 of case 60 (Fig. 2), and a part of float electrode 72 faces intermediate portion 33 of electrode 30 in the layering direction of piezoelectric element 50C (see a portion indicated by an arrow DR2). When float electrode 72 faces intermediate portion 33 of electrode 30, parasitic capacitance is generated therebetween; however, the parasitic capacitance hardly presents a large problem as long as the parasitic capacitance is generated at the bottom portion side (lower surface portion 34 side of electrode 30) relative to the center of piezoelectric element 50C (position of plane CS).

In each of the first and second embodiments, there is a region in which no electrode exists at all between the layers. On the other hand, according to the configuration of the present embodiment, at least one electrode exists between the layers. In other words, when float electrodes 72, 74, 76 and intermediate portions 33 of electrode 30 are projected in the layering direction of piezoelectric element 50C, a portion having no electrode formed therein does not exist in the projection images (the portion having no electrode formed therein does not exist because the projection images overlap with each other). This configuration serves to reduce a difference in thickness (difference in load) caused by the existence of the inner electrodes. Hence, occurrence of folding can be suppressed. It should be noted that this configuration can also be implemented in combination with the above-described first and second embodiments. The same effect is obtained also when float electrodes 72, 74 are formed to face intermediate portions 23 of electrode 20.

### [Experiment Example]

With reference to Fig. 25, the following describes experiment examples for the above-described reference art (comparative example) and the first to third embodiments. Examples 1 to 3 in Fig. 25 correspond to the above-described first to third embodiments, respectively. It is understood that larger folding occurs in the configuration of the reference art (comparative example) than those in the configurations of Examples 1 to 3 when the number of ceramic sheets (the number of piezoelectric layers) is increased in the pressing step. It is understood that a degree of suppression of folding is larger in the order of Examples 1, 2, and 3.

### [Fourth Embodiment]

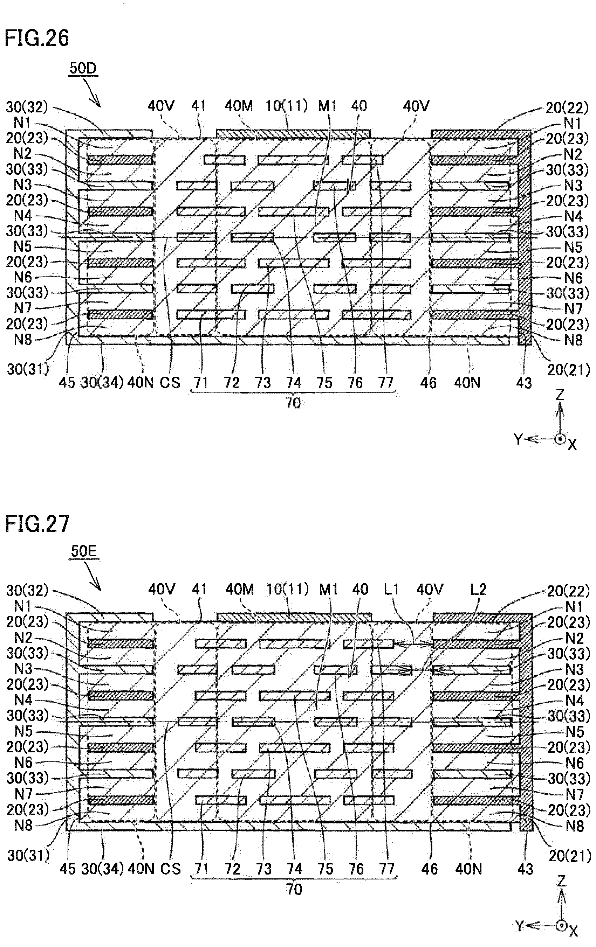

Fig. 26 is a cross sectional view showing a piezoelectric element 50D in a fourth embodiment. In piezoelectric element 50D, both end portions of a float electrode 77 furthest away from a bottom portion 62 of a case 60 (Fig. 2) in the layering direction of piezoelectric element 50D are located inwardly of positions of both end portions of each of the other float electrodes 71 to 76.

### [Fifth Embodiment]

Fig. 27 is a cross sectional view showing a piezoelectric element 50E in a fifth embodiment. In piezoelectric element 50E, an interval L1 between the inner electrodes (intermediate portions 23) of the transmission electrode (electrode 20) and float electrodes 71, 73, 75, 77 adjacent to each other with isolation region 40V being interposed therebetween is wider than an interval L2 between the inner electrodes (intermediate portions 33) of the common electrode (electrode 30) and float electrodes 72, 74, 76 adjacent to each other with isolation region 40V being interposed therebetween in the surface direction (leftward/rightward in the plane of sheet of Fig. 27) of inner surface 62S of bottom portion 62 of case 60 (Fig. 2).

### [Sixth Embodiment]

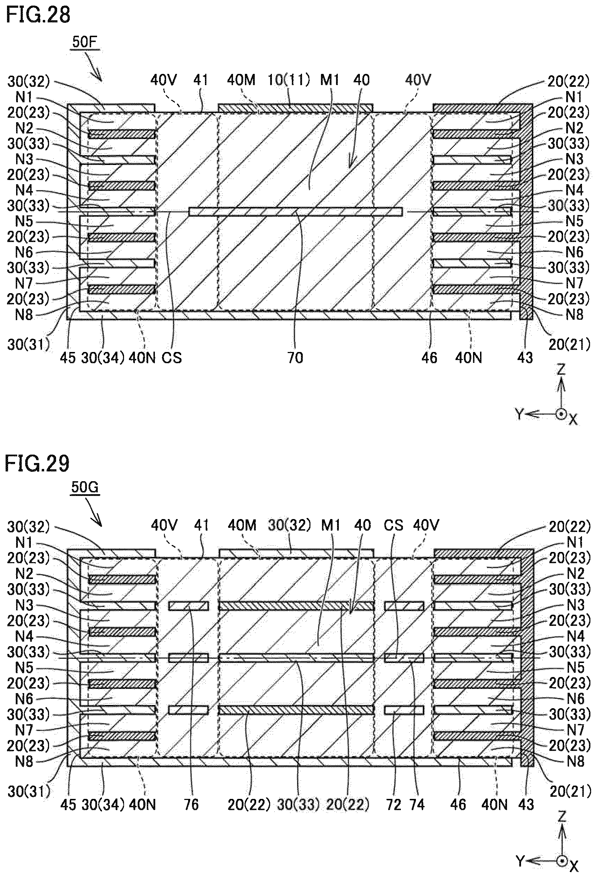

Fig. 28 is a cross sectional view showing a piezoelectric element 50F in a sixth embodiment. In each of the above-described embodiments, float electrode 70 is constituted of a plurality of regions; however, float electrode 70 may be constituted of only one region.

### [Seventh Embodiment]

Fig. 29 is a cross sectional view showing a piezoelectric element 50G in a seventh embodiment. In each of the above-described embodiments, float electrode 70 is provided in second constituent piezoelectric layer M1; however, float electrode 70 may be provided only in isolation region 40V.

### [Eighth Embodiment]

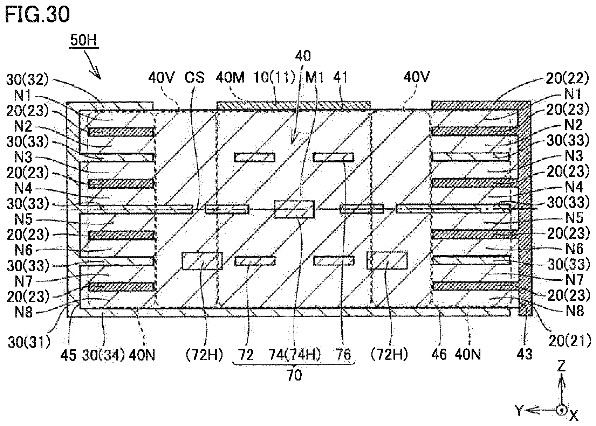

Fig. 30 is a cross sectional view showing a piezoelectric element 50H in an eighth embodiment. When the piezoelectric element has a plurality of float electrodes, at least one of the plurality of float electrodes preferably has a thickness thicker than that of the transmission electrode. In piezoelectric element 50H of the present embodiment, float electrodes 72H, 74H have thickness thicker than those of intermediate portions 23, 24 of electrode 20 (transmission electrode). Also according to this configuration, a portion (transmission region 40N) of piezoelectric element 50H for transmission of waves is formed to be separated from a portion (reception region 40M) for reception of waves. Hence, it can be said that there is provided a structure capable of independently adjusting both the sound pressure during transmission and the sensitivity during reception.

Further, float electrodes 72H, 74H have thicknesses thicker than those of intermediate portions 23, 24 of electrode 20 (transmission electrode). This configuration serves to further reduce variation of the whole of inner electrodes (inclusive of the float electrodes) in the in-plane direction when viewed in the thickness direction of the piezoelectric element. Accordingly, occurrence of folding can be suppressed further.

### [Other Embodiment]

Although the piezoelectric element is composed of a lead zirconate titanate based ceramic in each of the above-described embodiments, the piezoelectric element is not limited to this. For example, the piezoelectric element may be composed of a piezoelectric material of a non-lead based piezoelectric ceramic such as a potassium sodium niobate based ceramic, an alkali niobate based ceramic, or the like. Although each of silicones 66, 67 is composed of a silicone resin in the above-described embodiments, silicones 66, 67 are not limited to this. For example, each of silicones 66, 67 may be composed of a urethane resin or silicone foam resin as long as they are composed of a resin.

Heretofore, each of the embodiments according to the present invention has been described; however, the above disclosure is illustrative and is not restrictive in any respect. The technical scope of the present invention is defined by the terms of the claims.

### REFERENCE SIGNS LIST

1: sensor device; 10: electrode (reception electrode); 10C, 20C, 30C: connection position; 11: disk portion; 12: extending portion; 20: electrode (transmission electrode); 21, 31: side wall portion; 22, 32: upper surface portion; 23, 24, 33: intermediate portion; 30: electrode (common electrode); 32F: retracted portion; 34: lower surface portion; 40, M1, N1, N4, N8: piezoelectric layer; 40M: reception region; 40N: transmission region; 40V: isolation region; 41: upper surface; 42, 43, 44, 45: side surface; 46: lower surface; 50, 50A, 50B, 50C, 50D, 50E, 50F, 50G, 50H: piezoelectric element; 60: case; 61: cylindrical portion; 62: bottom portion; 62S: inner surface; 62T: outer surface; 63: sound absorbing material; 64: adhesive agent; 65: bonding agent; 66, 67: silicone; 70, 71, 72, 73, 74, 75, 76, 77: float electrode; 80T: leading end portion; 81, 82, 83: wiring pattern; 91: lower frame; 92: upper frame; 93, 94: resin sheet; 100: ultrasonic sensor; 101: microcomputer; 102: memory; 103: detection circuit; 104: signal generation circuit; 105: power supply; 106: reception amplifier; CS: plane; DR1: distance; LI, L2: interval; PI, P2, P3: both end portions.

## Claims

1. An ultrasonic sensor comprising:
a case having a bottom portion (62); and
a piezoelectric element (50A, 50B, 50C, 50D, 50E, 50F, 50G, 50H) bonded to an inner surface (62S) of the bottom portion and configured to undergo bending vibration together with the bottom portion,
the piezoelectric element including
a piezoelectric layer (40) including a transmission region (40N), a reception region (40M), and an isolation region (40V),
a common electrode (30) having a shape extending across both the transmission region and the reception region,
a transmission electrode (20) facing the common electrode with the transmission region being interposed therebetween, and
a reception electrode (10) facing the common electrode with the reception region being interposed therebetween,
the transmission region and the reception region being formed at positions adjacent to each other with the isolation region being interposed therebetween in a surface direction of the inner surface of the bottom portion,
**characterised by**
the transmission region including one first constituent piezoelectric layer or a plurality of first constituent piezoelectric layers (N1, N2, N3, N4, N5, N6, N7, N8) layered in a direction of being further away from the bottom portion, the plurality of first constituent piezoelectric layers being electrically connected in parallel,
the reception region including one second constituent piezoelectric layer or a plurality of second constituent piezoelectric layers (M1) layered in the direction of being further away from the bottom portion, the plurality of second constituent piezoelectric layers being electrically connected in parallel,
the number of the one or the plurality of first constituent piezoelectric layers included in the transmission region being different from the number of the one or the plurality of second constituent piezoelectric layers included in the reception region,
one or a plurality of float electrodes (70, 71, 72, 73, 74, 75, 76, 77) being provided in one of the transmission region and the reception region, the one of the transmission region and the reception region having a smaller number of layers.

2. The ultrasonic sensor according to claim 1, wherein
the number of the first constituent piezoelectric layers included in the transmission region is larger than the number of the one or the plurality of second constituent piezoelectric layers included in the reception region, and
the float electrode is provided in the reception region.

3. The ultrasonic sensor according to claim 2, wherein the float electrode is provided also in the isolation region.

4. The ultrasonic sensor according to claim 3, wherein the float electrode is provided to extend into the isolation region.

5. The ultrasonic sensor according to any one of claims 2 to 4, wherein the plurality of float electrodes are provided at positions in plane-symmetry with respect to a plane extending through a center of the piezoelectric element in a layering direction of the piezoelectric element.

6. The ultrasonic sensor according to any one of claims 2 to 5, wherein
the plurality of float electrodes are disposed at an interval therebetween in a layering direction of the piezoelectric element, and
both end portions of the float electrode furthest away from the bottom portion in the layering direction of the piezoelectric element are located inwardly of positions of both end portions of another float electrode.

7. The ultrasonic sensor according to any one of claims 2 to 6, wherein
the float electrode includes a facing portion located between a center of the piezoelectric element in a layering direction of the piezoelectric element and the bottom portion, and
the facing portion faces at least one of the transmission electrode and the common electrode in the layering direction of the piezoelectric element.

8. The ultrasonic sensor according to any one of claims 2 to 7, wherein an interval between an inner electrode of the transmission electrode and the float electrode adjacent to each other with the isolation region being interposed therebetween is wider than an interval between an inner electrode of the common electrode and the float electrode adjacent to each other with the isolation region being interposed therebetween in the surface direction of the inner surface of the bottom portion.

9. An ultrasonic sensor comprising:
a case having a bottom portion (62); and
a piezoelectric element (50A, 50B, 50C, 50D, 50E, 50F, 50G, 50H) bonded to an inner surface (62S) of the bottom portion and configured to undergo bending vibration together with the bottom portion,
the piezoelectric element including
a piezoelectric layer (40) including a transmission region (40N), a reception region (40M), and an isolation region (40V),
a common electrode (30) having a shape extending across both the transmission region and the reception region,
a transmission electrode (20) facing the common electrode with the transmission region being interposed therebetween, and
a reception electrode (10) facing the common electrode with the reception region being interposed therebetween,
the transmission region and the reception region being formed at positions adjacent to each other with the isolation region being interposed therebetween in a surface direction of the inner surface of the bottom portion,
the transmission region including one first constituent piezoelectric layer or a plurality of first constituent piezoelectric layers (N1, N2, N3, N4, N5, N6, N7, N8) layered in a direction of being further away from the bottom portion, the plurality of first constituent piezoelectric layers being electrically connected in parallel,
the reception region including one second constituent piezoelectric layer or a plurality of second constituent piezoelectric layers (M1) layered in the direction of being further away from the bottom portion, the plurality of second constituent piezoelectric layers being electrically connected in parallel,
the number of the one or the plurality of first constituent piezoelectric layers included in the transmission region being different from the number of the one or the plurality of second constituent piezoelectric layers included in the reception region,
**characterised by**
one or a plurality of float electrodes (70, 71, 72, 73, 74, 75, 76, 77) are provided in the isolation region.

10. The ultrasonic sensor according to any one of claims 1 to 9, wherein the piezoelectric element has the plurality of float electrodes, and
at least one of the plurality of float electrodes has a thickness thicker than a thickness of the transmission electrode.

## Patentansprüche

1. Ultraschallsensor, der Folgendes aufweist:
ein Gehäuse mit einem unteren Teil (62); und
ein piezoelektrisches Element (50A, 50B, 50C, 50D, 50E, 50F, 50G, 50H), das an eine innere Oberfläche (62S) des unteren Teils angefügt ist und zum Erfahren von Biegeschwingungen zusammen mit dem unteren Teil konfiguriert ist,
wobei das piezoelektrische Element Folgendes enthält:
eine piezoelektrische Schicht (40) mit einer Übertragungsregion (40N), einer Empfangsregion (40M) und einer Isolationsregion (40V),
eine gemeinsame Elektrode (30) mit einer Form, die sich über beide, die Übertragungsregion und die Empfangsregion, erstreckt,
eine Übertragungselektrode (20), die mit dazwischen angeordneter Übertragungsregion der gemeinsamen Elektrode gegenüberliegt, und
eine Empfangselektrode (10), die mit dazwischen angeordneter Empfangsregion der gemeinsamen Elektrode gegenüberliegt,
wobei die Übertragungsregion und die Empfangsregion an Positionen gebildet sind, die in einer Oberflächenrichtung der inneren Oberfläche des unteren Teils mit dazwischen angeordneter Isolationsregion nebeneinander liegen,
**dadurch gekennzeichnet, dass**
die Übertragungsregion eine erste einen Teil davon bildende piezoelektrische Schicht oder mehrere erste einen Teil davon bildende piezoelektrische Schichten (N1, N2, N3, N4, N5, N6, N7, N8) enthält, die in einer Richtung der weiteren Entfernung vom unteren Teil geschichtet sind, wobei die mehreren ersten einen Teil davon bildenden piezoelektrischen Schichten elektrisch parallel geschaltet sind,
die Empfangsregion eine zweite einen Teil davon bildende piezoelektrische Schicht oder mehrere zweite einen Teil davon bildende piezoelektrische Schichten (M1) enthält, die in der Richtung der weiteren Entfernung vom unteren Teil geschichtet sind, wobei die mehreren zweiten einen Teil davon bildenden piezoelektrischen Schichten elektrisch parallel geschaltet sind,
die Zahl der in der Übertragungsregion enthaltenen einen oder mehreren ersten einen Teil davon bildenden piezoelektrischen Schichten von der Zahl der in der Empfangsregion enthaltenen einen oder mehreren zweiten einen Teil davon bildenden piezoelektrischen Schichten verschieden ist,
eine oder mehrere schwimmende Elektroden (70, 71, 72, 73, 74, 75, 76, 77) in einer von der Übertragungsregion und der Empfangsregion bereitgestellt ist, wobei die eine von der Übertragungsregion und der Empfangsregion eine kleinere Anzahl von Schichten hat.

2. Ultraschallsensor nach Anspruch 1 wobei
die Zahl der in der Übertragungsregion enthaltenen ersten einen Teil davon bildenden piezoelektrischen Schichten größer ist als die Zahl der in der Empfangsregion enthaltenen einen oder mehreren zweiten einen Teil davon bildenden piezoelektrischen Schichten ist und
die schwimmende Elektrode in der Empfangsregion bereitgestellt ist.

3. Ultraschallsensor nach Anspruch 2, wobei die schwimmende Elektrode auch in der Isolationsregion bereitgestellt ist.

4. Ultraschallsensor nach Anspruch 3, wobei die schwimmende Elektrode so bereitgestellt ist, dass sie sich in die Isolationsregion erstreckt.

5. Ultraschallsensor nach einem der Ansprüche 2 bis 4, wobei die mehreren schwimmenden Elektroden an Positionen bereitgestellt sind, die in Bezug auf eine sich durch eine Mitte des piezoelektrischen Elements in einer Schichtungsrichtung des piezoelektrischen Elements erstreckende Ebene in Ebenensymmetrie sind.

6. Ultraschallsensor nach einem der Ansprüche 2 bis 5, wobei
die mehreren schwimmenden Elektroden in einem Abstand dazwischen in einer Schichtungsrichtung des piezoelektrischen Elements angeordnet sind und
beide Endteile der schwimmenden Elektrode, die vom unteren Teil in der Schichtungsrichtung des piezoelektrischen Elements am weitesten entfernt sind, einwärts von Positionen beider Endteile einer weiteren schwimmenden Elektrode liegen.

7. Ultraschallsensor nach einem der Ansprüche 2 bis 6, wobei
die schwimmende Elektrode einen gegenüberliegenden Teil enthält, der sich zwischen einer Mitte des piezoelektrischen Elements in einer Schichtungsrichtung des piezoelektrische Elements und dem unteren Teil befindet, und
der gegenüberliegende Teil wenigstens einer von der Übertragungselektrode und der gemeinsamen Elektrode in der Schichtungsrichtung des piezoelektrischen Elements gegenüberliegt.

8. Ultraschallsensor nach einem der Ansprüche 2 bis 7, wobei ein Abstand zwischen einer inneren Elektrode der Übertragungselektrode und der schwimmenden Elektrode, die mit dazwischen angeordneter Isolationsregion nebeneinander liegen, breiter ist als ein Abstand zwischen einer inneren Elektrode der gemeinsamen Elektrode und der schwimmenden Elektrode, die mit dazwischen angeordneter Isolationsregion nebeneinander liegen, in der Oberflächenrichtung der inneren Oberfläche des unteren Teils.

9. Ultraschallsensor, der Folgendes aufweist:
ein Gehäuse mit einem unteren Teil (62); und
ein piezoelektrisches Element (50A, 50B, 50C, 50D, 50E, 50F, 50G, 50H), das an eine innere Oberfläche (62S) des unteren Teils angefügt ist und zum Erfahren von Biegeschwingungen zusammen mit dem unteren Teil konfiguriert ist,
wobei das piezoelektrische Element Folgendes enthält:
eine piezoelektrische Schicht (40) mit einer Übertragungsregion (40N), einer Empfangsregion (40M) und einer Isolationsregion (40V),
eine gemeinsame Elektrode (30) mit einer Form, die sich über beide, die Übertragungsregion und die Empfangsregion, erstreckt,
eine Übertragungselektrode (20), die mit dazwischen angeordneter Übertragungsregion der gemeinsamen Elektrode gegenüberliegt, und
eine Empfangselektrode (10), die mit dazwischen angeordneter Empfangsregion der gemeinsamen Elektrode gegenüberliegt,
wobei die Übertragungsregion und die Empfangsregion an Positionen gebildet sind, die in einer Oberflächenrichtung der inneren Oberfläche des unteren Teils mit dazwischen angeordneter Isolationsregion nebeneinander liegen,
wobei die Übertragungsregion eine erste einen Teil davon bildende piezoelektrische Schicht oder mehrere erste einen Teil davon bildende piezoelektrische Schichten (N1, N2, N3, N4, N5, N6, N7, N8) enthält, die in einer Richtung der weiteren Entfernung vom unteren Teil geschichtet sind, wobei die mehreren ersten einen Teil davon bildenden piezoelektrischen Schichten elektrisch parallel geschaltet sind,
wobei die Empfangsregion eine zweite einen Teil davon bildende piezoelektrische Schicht oder mehrere zweite einen Teil davon bildende piezoelektrische Schichten (M1) enthält, die in der Richtung der weiteren Entfernung vom unteren Teil geschichtet sind, wobei die mehreren zweiten einen Teil davon bildenden piezoelektrischen Schichten elektrisch parallel geschaltet sind,
wobei die Zahl der in der Übertragungsregion enthaltenen einen oder mehreren ersten einen Teil davon bildenden piezoelektrischen Schichten von der Zahl der in der Empfangsregion enthaltenen einen oder mehreren zweiten einen Teil davon bildenden piezoelektrischen Schichten verschieden ist,
**dadurch gekennzeichnet, dass**
eine oder mehrere schwimmende Elektroden (70, 71, 72, 73, 74, 75, 76, 77) in der Isolationsregion bereitgestellt sind.

10. Ultraschallsensor nach einem der Ansprüche 1 bis 9, wobei
das piezoelektrische Element die mehreren schwimmenden Elektroden hat und
wenigstens eine der mehreren schwimmenden Elektroden eine Dicke hat, die dicker als eine Dicke der Übertragungselektrode ist.

## Revendications

1. Capteur à ultrasons comprenant :
un boîtier ayant une partie de fond (62) ; et
un élément piézoélectrique (50A, 50B, 50C, 50D, 50E, 50F, 50G, 50H) lié à une surface intérieure (62S) de la partie de fond et configuré pour subir une vibration de flexion avec la partie de fond.
l'élément piézoélectrique comprenant
une couche piézoélectrique (40) comprenant une région de transmission (40N), une région de réception (40M) et une région d'isolement (40V),
une électrode commune (30) ayant une forme s'étendant en travers de la région de transmission et de la région de réception toutes les deux,
une électrode de transmission (20) faisant face à l'électrode commune avec la région de transmission étant interposée entre elles, et
une électrode de réception (10) faisant face à l'électrode commune avec la région de réception étant interposée entre elles,
la région de transmission et la région de réception étant formées à des positions adjacentes l'une à l'autre avec la région d'isolement étant interposée entre elles dans une direction de surface de la surface intérieure de la partie de fond,
**caractérisé par**
la région de transmission comprenant une première couche piézoélectrique constituante ou une pluralité de premières couches piézoélectriques constituantes (N1, N2, N3, N4, N5, N6, N7, N8) disposées en couches dans une direction d'éloignement de la partie de fond, la pluralité de premières couches piézoélectriques constituantes étant électriquement connectées en parallèle,
la région de réception comprenant une deuxième couche piézoélectrique constituante ou une pluralité de deuxièmes couches piézoélectriques constituantes (M1) disposées en couches dans la direction d'éloignement de la partie de fond, la pluralité de deuxièmes couches piézoélectriques constituantes étant électriquement connectées en parallèle,
le nombre de l'une ou de la pluralité de premières couches piézoélectriques constituantes incluses dans la région de transmission étant différent du nombre de l'une ou de la pluralité de deuxièmes couches piézoélectriques constituantes incluses dans la région de réception,
une ou une pluralité d'électrodes flottantes (70, 71, 72, 73, 74, 75, 76, 77) étant fournies dans l'une d'entre la région de transmission et la région de réception, l'une d'entre la région de transmission et la région de réception ayant un plus petit nombre de couches.

2. Capteur à ultrasons selon la revendication 1, dans lequel
le nombre de premières couches piézoélectriques constituantes incluses dans la région de transmission est plus grand que le nombre de l'une ou de la pluralité de deuxièmes couches piézoélectriques constituantes incluses dans la région de réception, et
l'électrode flottante est fournie dans la région de réception.

3. Capteur à ultrasons selon la revendication 2, dans lequel l'électrode flottante est fournie aussi dans la région d'isolement.

4. Capteur à ultrasons selon la revendication 3, dans lequel l'électrode flottante est fournie pour s'étendre dans la région d'isolement.

5. Capteur à ultrasons selon l'une quelconque des revendications 2 à 4, dans lequel la pluralité d'électrodes flottantes sont fournies à des positions en symétrie plane par rapport à un plan s'étendant à travers un centre de l'élément piézoélectrique dans une direction de disposition des couches de l'élément piézoélectrique.

6. Capteur à ultrasons selon l'une quelconque des revendications 2 à 5, dans lequel
la pluralité d'électrodes flottantes sont disposées à un intervalle entre elles dans une direction de disposition des couches de l'élément piézoélectrique, et
les deux parties d'extrémité de l'électrode flottante la plus éloignée de la partie de fond dans la direction de disposition des couches de l'élément piézoélectrique sont situées vers l'intérieur des positions des deux parties d'extrémité d'une autre électrode flottante.

7. Capteur à ultrasons selon l'une quelconque des revendications 2 à 6, dans lequel
l'électrode flottante comprend une partie de face située entre un centre de l'élément piézoélectrique dans une direction de disposition des couches de l'élément piézoélectrique et la partie de fond, et
la partie de face fait face à au moins l'une d'entre l'électrode de transmission et l'électrode commune dans la direction de disposition des couches de l'élément piézoélectrique.

8. Capteur à ultrasons selon l'une quelconque des revendications 2 à 7, dans lequel un intervalle entre une électrode intérieure de l'électrode de transmission et l'électrode flottante adjacentes l'une à l'autre avec la région d'isolement étant interposée entre elles est plus large qu'un intervalle entre une électrode intérieure de l'électrode commune et l'électrode flottante adjacentes l'une à l'autre avec la région d'isolement étant interposée entre elles dans la direction de surface de la surface intérieure de la partie de fond.

9. Capteur à ultrasons comprenant :
un boîtier ayant une partie de fond (62) ; et
un élément piézoélectrique (50A, 50B, 50C, 50D, 50E, 50F, 50G, 50H) lié à une surface intérieure (62S) de la partie de fond et configuré pour subir une vibration de flexion avec la partie de fond.
l'élément piézoélectrique comprenant
une couche piézoélectrique (40) comprenant une région de transmission (40N), une région de réception (40M) et une région d'isolement (40V),
une électrode commune (30) ayant une forme s'étendant en travers de la région de transmission et de la région de réception toutes les deux,
une électrode de transmission (20) faisant face à l'électrode commune avec la région de transmission étant interposée entre elles, et
une électrode de réception (10) faisant face à l'électrode commune avec la région de réception étant interposée entre elles,
la région de transmission et la région de réception étant formées à des positions adjacentes l'une à l'autre avec la région d'isolement étant interposée entre elles dans une direction de la surface de la surface intérieure de la partie de fond,
la région de transmission comprenant une première couche piézoélectrique constituante ou une pluralité de premières couches piézoélectriques constituantes (N1, N2, N3, N4, N5, N6, N7, N8) disposées en couches dans une direction d'éloignement de la partie de fond, la pluralité de premières couches piézoélectriques constituantes étant électriquement connectées en parallèle,
la région de réception comprenant une deuxième couche piézoélectrique constituante ou une pluralité de deuxièmes couches piézoélectriques constituantes (M1) disposées en couches dans la direction d'éloignement de la partie de fond, la pluralité de deuxièmes couches piézoélectriques constituantes étant électriquement connectées en parallèle,
le nombre de l'une ou de la pluralité de premières couches piézoélectriques constituantes incluses dans la région de transmission étant différent du nombre de l'une ou de la pluralité de deuxièmes couches piézoélectriques constituantes incluses dans la région de réception,
**caractérisé par le fait**
**que** l'une ou une pluralité d'électrodes flottantes (70, 71, 72, 73, 74, 75, 76, 77) sont fournies dans la région d'isolement.

10. Capteur à ultrasons selon l'une quelconque des revendications 1 à 9, dans lequel
l'élément piézoélectrique a une pluralité d'électrodes flottantes, et
au moins l'une de la pluralité d'électrodes flottantes a une épaisseur plus épaisse qu'une épaisseur de l'électrode de transmission.
